# EUROPEAN PATENT SPECIFICATION

(11) **EP 4 549 970 B1**
(45) Date of publication and mention of the grant of the patent: **28.10.2026**
(21) Application number: 23865728.2
(22) Date of filing: 03.08.2023
(51) Int. Cl.: B60L 3/00, B60L 3/04, G01R 31/392, B60L 58/12, B60L 58/16, G01R 31/3842, G01R 31/396, H01M 10/48, B60L 3/12, B60L 58/19, B60L 58/21, B60L 58/22

(54) **BATTERY CELL DEGRADATION DIAGNOSIS METHOD AND BATTERY SYSTEM USING THE SAME**
VERFAHREN ZUR DIAGNOSE DES SCHÄDIGUNGSGRADES VON BATTERIEZELLEN UND BATTERIESYSTEM DAMIT
PROCÉDÉ DE DIAGNOSTIC DU DEGRÉ DE DÉTÉRIORATION DE CELLULES DE BATTERIE, ET SYSTÈME DE BATTERIE L'UTILISANT

(30) Priority: 15.09.2022 KR 20220116272
(43) Date of publication of application: 07.05.2025
(73) Proprietor: LG Energy Solution, Ltd., Seoul 07335 (KR)
(72) Inventor: LEE, Bokyun, Daejeon 34122 (KR); SONG, Changyong, Daejeon 34122 (KR)
(74) Representative: Plasseraud IP
(86) International application number: PCT/KR2023/011448
(87) International publication number: WO 2024/058428

(56) References cited:
- WO-A1-2021/006566
- KR-A- 20120 120 889
- KR-A- 20170 022 746
- KR-A- 20210 074 003
- KR-A- 20220 036 701
- KR-A- 20220 056 150
- KR-B1- 102 148 204
- US-A1- 2022 155 380
- US-A1- 2022 276 314

## Description

### [Technical Field]

### CROSS-REFERENCE TO RELATED APPLICATIONS

This application claims priority to and the benefit of Korean Patent Application No. 10-2022-0116272 filed in the Korean Intellectual Property Office on September 15, 2022.

The present disclosure relates to a method for diagnosing a degree of degradation of a battery cell and a battery system using the same.

### [Background Art]

A battery includes a plurality of battery cells, and a cell capacity of each of the plurality of battery cells degrades as the battery is used. If degradation rates of the plurality of battery cells are similar, a cell capacity difference between the plurality of battery cells may be within an allowable range. However, if there is a defective battery cell among the plurality of battery cells, the cell capacity difference between the defective battery cell and other battery cells may increase.

The battery management system may monitor a degree of cell capacity degradation for each of the plurality of battery cells, and diagnose a battery cell of which a degree of cell capacity degradation is greater than those of the other battery cells as a defective cell when a difference between the plurality of degrees of cell capacity degradation of the plurality of battery cells is greater than or equal to a predetermined threshold value. However, since the degradation of the battery cell progresses over a considerable period of time, it takes a considerable amount of time for the cell capacity of the battery cell to degrade to a condition for diagnosing a defect. During this period, a battery cell of which a degree of cell capacity degradation is large may cause damage to the other battery cells of which degrees of cell capacity degradation are relatively small, which may eventually lead to damage to the entire battery.

US 2022/276314 A1 discloses a battery management apparatus which diagnoses a state of a battery cell based on a comparison of capacity-voltage differential profiles of a subset of charging and discharging cycles with each other. Specifically, the battery management apparatus diagnoses a state of the battery cell according to a change pattern of a peak associated with a positive electrode reaction area and a peak associated with an available lithium loss in the capacity-voltage differential profile. The apparatus comprises a voltage sensor and a current sensor, measuring the battery cell voltage and current during charging and discharging cycles.

### [Disclosure]

### [Technical Problem]

The present disclosure attempts to provide a method for diagnosing a degree of degradation of a battery cell and a battery system using the same capable of detecting a defective battery cell before damage to a battery occurs.

### [Technical Solution]

An exemplary embodiment of the present disclosure provides a battery system as defined in the appended claims.

Another exemplary embodiment of the present disclosure provides a method according to claim 10 for diagnosing degrees of degradation of a plurality of battery cells constituting a battery pack by a battery management system.

### [Advantageous Effects]

The method for diagnosing a degree of degradation of a battery cell according to an exemplary embodiment and the battery system using the same are capable of detecting a battery cell that is abnormal due to degradation of its capacity before damage to the battery occurs.

### [Description of the Drawings]

FIG. 1 is a schematic diagram showing a battery system according to an exemplary embodiment.
FIG. 2 is a diagram showing a partial configuration of an MCU according to an exemplary embodiment.
FIG. 3 is a flowchart showing a method for diagnosing a degree of cell capacity degradation of a battery cell according to an exemplary embodiment.
FIG. 4 is a graph showing a relationship between a cell capacity difference and accumulated energy according to an exemplary embodiment.

### [Mode for Invention]

The suffixes "module" and/or "unit" for components used in the description below are assigned or mixed in consideration of easiness in writing the specification and do not have distinctive meanings or roles by themselves. In addition, the terms "-er", "-or", and "module" described in the specification refer to a unit for processing at least one function or operation, which may be implemented by hardware, software or a combination thereof.

In addition, in describing exemplary embodiments disclosed in the present specification, detailed descriptions of relevant known technologies will be omitted if they unnecessarily obscure the gist of the exemplary embodiments disclosed in the present specification. Further, the accompanying drawings are provided only to help easily understand exemplary embodiments disclosed in the present specification. It should be understood that the technical idea disclosed in the present specification is not limited by the accompanying drawings, and covers all modifications, equivalents, and substitutions within the technical scope of the present disclosure.

Terms including ordinal numbers such as first and second may be used to describe various components, but these components are not limited by these terms. These terms are used only for the purpose of distinguishing one component from another component.

It is to be understood that when one component is referred to as being "connected to" or "coupled to" another component, one component may be connected or coupled directly to another component or be connected or coupled to another component with an intervening component therebetween. On the other hand, it is to be understood that when one component is referred to as being "directly connected to" or "directly coupled to" another component, one component may be connected to another component with no intervening component therebetween.

It should be understood that terms "include", "have", and the like used in the present application specify the presence of features, numerals, steps, operations, components, parts, or combinations thereof mentioned in the specification, but do not preclude the presence or addition of one or more other features, numerals, steps, operations, components, parts, or combinations thereof.

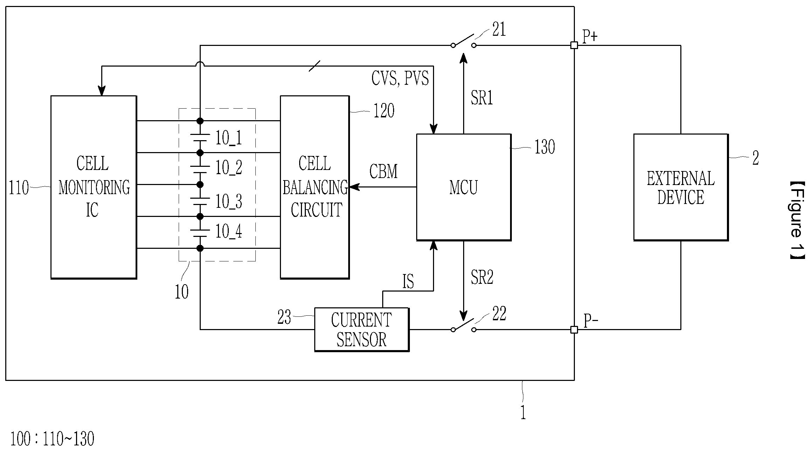

FIG. 1 is a schematic diagram showing a battery system according to an exemplary embodiment.

In FIG. 1, an external device 2 may be connected between both output terminals P+ and P- of the battery system 1, and a battery pack 10 may be electrically connected to the external device 2 when relays 21 and 22 are closed. Although it is illustrated in FIG. 1 that the external device 2 is connected to the battery system 1, this is an example to help understand the battery system 1, and the invention is not limited thereto.

In a case where the external device 2 is an electric load, the battery system 1 may be discharged by operating as a power supply that supplies energy to the electric load 2. The electronic load may be a moving means or an energy storage system (ESS), and the moving means may be, for example, an electric vehicle, a hybrid vehicle, or a smart mobility. In a case where the external device 2 is a charger, the battery system 1 may be charged by receiving energy from a power system through the charger 2.

The battery system 1 includes a battery pack 10, two relays 21 and 22, a current sensor 23, and a battery management system (BMS) 100.

The battery pack 10 includes a plurality of battery cells 10_1 to 10_4 connected to each other in series. Although it is illustrated in FIG. 1 that the battery pack 10 includes four battery cells 10_1 to 10_4 connected to each other in series, but this is an example and the invention is not limited thereto. For example, five or more battery cells may be connected to each other in series, or a plurality of sets, each including two or more battery cells connected to in parallel, may be connected to each other in series.

The relay 21 may be connected between a positive pole of the battery pack 10 and the output terminal P+, and the relay 22 is connected between a negative pole of the battery pack 10 and the output terminal P-, and the relays 21 and 22 may be controlled to be opened or closed according to a control of a main control unit (MCU) 130 of the BMS 100. For example, the MCU 130 may generate enable-level relay control signals SR1 and SR2 and transmit the generated enable-level relay control signals SR1 and SR2 to the relays 21 and 22, and the relays 21 and 22 may be closed according to the enable-level relay control signals SR1 and SR2. In addition, the MCU 130 may generate disable-level relay control signals SR1 and SR2 and transmit the generated disable-level relay control signals SR1 and SR2 to the relays 21 and 22, and the relays 21 and 22 may be opened according to the disable-level relay control signals SR1 and SR2. During charging or discharging of the battery pack 10, the relays 21 and 22 may be closed to constitute a charging current path or a discharging current path.

The current sensor 23 may sense a current flowing through the battery pack 10 (hereinafter referred to as a battery pack current), generate a current sensing signal IS indicating the sensed battery pack current, and transmit the generated current sensing signal IS to the MCU 130. Hereinafter, the current flowing through the battery pack 10 will be referred to as a battery pack current. Since the plurality of battery cells 10_1 to 10_4 are connected to each other in series, a current flowing through the plurality of battery cells 10_1 to 10_4 may be the same as the battery pack current. In a case where a plurality of battery cells are connected to each other in parallel, a current sensor may be provided for each current path. In a case where the battery system 1 includes a plurality of battery packs, current sensors may be provided in the same number as the number of battery packs to measure a current flowing through each of the battery packs. The battery system 1 according to an exemplary embodiment may include current sensors in such a number as to sense a current flowing through each of the plurality of battery cells constituting the battery pack, and each of the current sensors may be connected to the corresponding battery cell in series at a location suitable for measuring a cell current of the corresponding battery cell.

The BMS 100 includes a cell monitoring IC 110, a cell balancing unit 120, and an MCU 130. The BMS 100 may be connected to the plurality of battery cells 10_1 to 10_4, control a charge/discharge current of the battery pack 10 based on information such as the cell voltage of each of the plurality of battery cells 10_1 to 10_4 and the battery pack current, and control an cell balancing operation for the plurality of battery cells 10_1 to 10_4.

For example, the cell monitoring IC 110 may measure a cell voltage of each of the plurality of battery cells 10_1 to 10_4 and a voltage of the battery pack 10 (hereinafter referred to as a battery pack voltage) at each monitoring cycle, and transmit voltage sensing signals CVS and PVS indicating the measured plurality of cell voltages and the measured battery pack voltage to the MCU 130. The MCU 130 may determine whether cell balancing is necessary based on the voltage sensing signal (CVS). Among the cell voltages of the plurality of battery cells 10_1 to 10_4, the lowest cell voltage may be lower than the other cell voltages by a predetermined threshold value or more, or the highest cell voltage may be higher than the other cell voltages by the predetermined threshold value or more. When a difference between the cell voltages of the plurality of battery cells 10_1 to 10_4 is greater than or equal to the predetermined threshold value, the MCU 130 may determine that cell balancing is necessary. When it is determined that cell balancing is necessary, the MCU 130 may control the cell balancing unit 120 to perform a cell balancing operation. For example, the MCU 130 may generate a control signal CBM to discharge a battery cell having a cell voltage higher than a predetermined reference voltage among the plurality of cell voltages and transmit the generated control signal CBM to the cell balancing unit 120. The cell balancing unit 120 may form a discharging path capable of discharging the battery cell having a cell voltage higher than the predetermined reference voltage, discharge the battery cell having a cell voltage higher than the predetermined reference voltage, or store energy generated while discharging the battery cell having a cell voltage higher than the predetermined reference voltage. The MCU 130 may generate a control signal CBM to charge a battery cell having a cell voltage lower than the predetermined reference voltage among the plurality of cell voltages and transmit the generated control signal CBM to the cell balancing unit 120. The cell balancing unit 120 may form a charging path capable of charging the battery cell having a cell voltage lower than the predetermined reference voltage and charge the battery cell having a cell voltage lower than the predetermined reference voltage. The energy transferred from discharged battery cell may be used for charging for cell balancing. The predetermined reference voltage may be determined based on the plurality of cell voltages. For example, an average value of the plurality of cell voltages or a median value between the plurality of cell voltages may be determined as the reference voltage.

The MCU 130 may diagnose degrees of cell capacity degradation for the plurality of battery cells 10_1 to 10_4. The MCU 130 may accumulate one of charging energy and discharging energy for the battery pack 10 and compute the accumulated energy, and calculate a degree of change (e.g., slope) in cell capacity difference for each of the plurality of battery cells 10_1 to 10_4 whenever the accumulated energy of the battery pack 10 increases by a predetermined unit. The period during which the accumulated energy increases by the reference energy unit is called an accumulation cycle. The MCU 130 may diagnose whether the battery cell is abnormal according to a result of comparing the slope calculated every accumulation cycle with a predetermined threshold value. As the degree of change in cell capacity difference increases, the degree of cell capacity degradation can be considered to be greater. That is, taking into account that the degree of change in cell capacity difference increases when the cell capacity of the battery cell decreases according to the degradation of the battery cell, the degree of change in cell capacity difference be used to diagnose the degree of cell capacity degradation. In an exemplary embodiment, the degree of change in cell capacity difference refers to a difference between a cell capacity difference at a current accumulation cycle and a cell capacity difference at a previous accumulation cycle for each battery cell. The previous accumulation cycle may be a cycle immediately preceding the current accumulation cycle. The MCU 130 may calculate a cell capacity of each of the plurality of battery cells 10_1 to 10_4 every predetermined cell capacity calculation cycle in order to calculate a cell capacity difference. The MCU 130 may calculate the cell capacity of each battery cell based on a cell voltage of each of the plurality of battery cells 10_1 to 10_4.

The MCU 130 may be implemented as a semiconductor intellectual property (IP), e.g., an application specific IC (ASIC), and a program configured by a set of control instructions for diagnosing a degree of cell capacity degradation for each of the plurality of battery cells 10_1 to 10_4 may be installed in the ASIC. In the following description, each component of the MCU 130 may be implemented by a set of control instructions for performing the same operation among all control instructions.

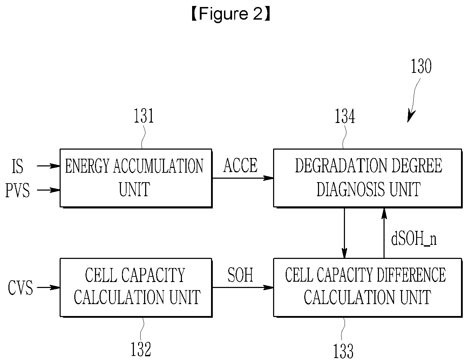

FIG. 2 is a diagram showing a partial configuration of the MCU according to an exemplary embodiment.

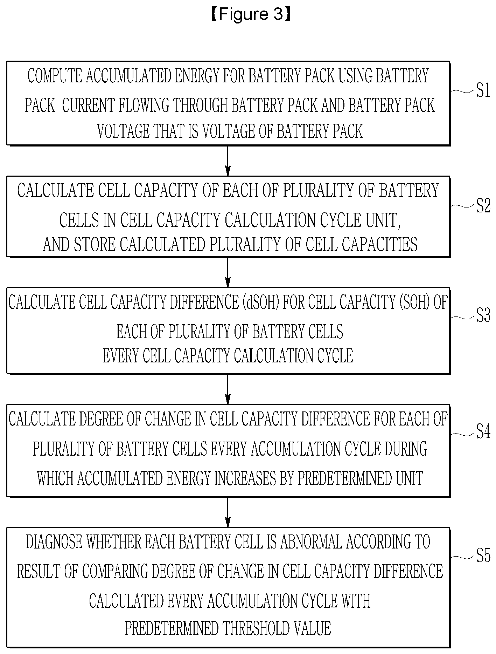

FIG. 3 is a flowchart showing a method for diagnosing a degree of cell capacity degradation of a battery cell according to an exemplary embodiment.

In FIG. 2, components for diagnosing a degree of cell capacity degradation of a battery cell are illustrated.

As illustrated in FIG. 2, the MCU 130 may include an energy accumulation unit 131, a cell capacity calculation unit 132, a cell capacity difference calculation unit 133, and a degradation degree diagnosis unit 134.

The energy accumulation unit 131 may accumulate one of charging energy and discharging energy for the battery pack 10 and compute the accumulated energy. For example, the energy accumulation unit 131 may compute one of charging energy and discharging energy for the battery pack 10 as the accumulated energy, using a battery pack current indicated by the current sensing signal IS and a battery pack voltage indicated by the voltage sensing signal PVS (S1). A time at which the battery pack current indicated by the current sensing signal IS is measured and a time at which the battery pack voltage indicated by the voltage sensing signal PVS is measured may be synchronized with each other by a control of the MCU 130. For example, the MCU 130 may instruct the current sensor 23 to measure a current and the cell monitoring IC 110 to measure a battery pack voltage every predetermined monitoring cycle.

Specifically, in a case where the energy accumulation unit 131 calculates accumulated energy of charging energy, the energy accumulation unit 131 may calculate the accumulated energy by multiplying a battery pack current and a battery pack voltage every monitoring cycle during a charging period in which the battery pack 10 is charged to calculate charging energy, and integrating the charging energy calculated during the charging period. In a case where the energy accumulation unit 131 calculates accumulated energy of discharging energy, the energy accumulation unit 131 may calculate the accumulated energy by multiplying a battery pack current and a battery pack voltage every monitoring cycle during a discharging period in which the battery pack 10 is discharged to calculate discharging energy, and integrating the discharging energy calculated during the discharging period. The energy accumulation unit 131 may transmit the calculated accumulated energy value ACCE to the degeneration degree diagnosis unit 134.

The cell capacity calculation unit 132 may calculate cell capacities for each of the plurality of battery cells 10_1 to 10_4 in units of the predetermined cell capacity calculation cycle, and store the calculated plurality of cell capacities (S2). The cell capacity indicates an amount of charge that a battery is allowed to hold, and the cell capacity may be expressed as a state of health (SOH). In an exemplary embodiment, the SOH, which is a ratio of a current cell capacity of the battery cell to an initial cell capacity of the battery cell, may be used as a factor indicating the current cell capacity of the battery cell. The state before the battery cell is used can be called "initial".

The cell capacity calculation cycle may be set in various ways depending on the design. For example, a period from a time point when the BMS 100 is powered on to a time point when the BMS 100 is powered off may be set as the cell capacity calculation cycle. The term "powered on" means that a power supply is connected to the BMS 100 to supply power required for operating the BMS 100, and the term "powered off" means that the power supply connected to the BMS 100 is blocked to cut off the supply of the power to the BMS 100. When the BMS 100 is powered on, the MCU 130 may also be connected to the power supply and turned on, and when the BMS 100 is powered off, the MCU 130 may also be turned off by blocking the power supply. The power-on and the power-off of the BMS 100 may be controlled according to a user's operation or according to a control instruction from a higher-level controller.

Specifically, the cell capacity calculation unit 132 may accumulate a current flowing through each of the plurality of battery cells 10_1 to 10_4 during the cell capacity calculation cycle and calculate an accumulated current amount of each of the plurality of battery cells 10_1 to 10_4, calculate an SOC change amount of each of the plurality of battery cells 10_1 to 10_4 during the cell capacity calculation cycle, and calculate a cell capacity (SOH) by dividing the accumulated current amount by the SOC change amount during the cell capacity calculation cycle for each of the plurality of battery cells 10_1 to 10_4. In an exemplary embodiment, since the plurality of battery cells 10_1 to 10_4 are connected to each other in series, the plurality of battery cells 10_1 to 10_4 may have the same accumulated current amount. However, unlike an exemplary embodiment, in a case where a plurality of battery cells are connected to each other in parallel, the battery system 1 may include a current sensor for each current path, and the cell capacity calculation unit 132 may calculate an accumulated current amount for each of the plurality of battery cells by collecting a result of measuring a current in each current path.

The cell capacity calculation unit 132 may estimate an SOC at a start time point of the cell capacity calculation cycle and an SOC at an end time point of the cell capacity calculation cycle based on a cell voltage or an open circuit voltage (OCV) of each of the plurality of battery cells 10_1 to 10_4, and calculate a difference between the SOC at the start time point and the SOC at the end time point as the SOC change amount. Concerning the method for estimating an SOC for each of the plurality of battery cells 10_1 to 10_4, any of the various known techniques may be applied to an exemplary embodiment. For example, the BMS 100 according to an exemplary embodiment may include a look-up table in which condition factors are cell temperature and OCV (or cell voltage), and a factor determined according to the condition factors is SOC. The cell capacity calculation unit 132 may derive an SOC corresponding to an OCV (or a cell voltage) calculated according to a cell voltage measured at a current cell temperature from the look-up table. If necessary, the cell capacity calculation unit 132 may estimate an SOC under conditions that are not recorded in the look-up table, using an interpolation method.

The cell capacity difference calculation unit 133 may calculate a cell capacity difference dSOH for a cell capacity SOH of each of the plurality of battery cells 10_1 to 10_4 every cell capacity calculation cycle (S3). The cell capacity difference according to an exemplary embodiment may refer to a change in cell capacity during the cell capacity calculation cycle for each of the plurality of battery cells 10_1 to 10_4. Therefore, the cell capacity difference calculation unit 133 may calculate, as a cell capacity difference dSOH_n for each of the plurality of battery cells 10_1 to 10_4, a difference SOH_n1-SOH_n2 between a cell capacity SOH_n1 at a start time point of a nth cell capacity calculation cycle and a cell capacity SOH_n2 at an end time point of the nth cell capacity calculation cycle. "n" may be a natural number greater than or equal to 1 that indicates the number of times the cell capacity calculation cycle has elapsed from a time point at which the battery pack 10 began to be used to an arbitrary time point (e.g., a current time).

The degradation degree diagnosis unit 134 may calculate a degree of change in cell capacity difference for each of the plurality of battery cells 10_1 to 10_4 every accumulation cycle during which accumulated energy increases by a predetermined unit (S4).

The degradation degree diagnosis unit 134 receives an accumulated energy value from the energy accumulation unit 131, receives from the cell capacity difference calculation unit 133 and stores a cell capacity difference dSOH for each of the plurality of battery cells 10_1 to 10_4 during a cell capacity calculation cycle corresponding to a time point at which the accumulated energy value increases by a predetermined reference energy unit, and calculates a degree of change (e.g., slope) between a cell capacity difference corresponding to a current accumulation cycle (hereinafter, a current cell capacity difference dSOH_n) and a cell capacity difference corresponding to an immediately previous accumulation cycle (hereinafter, an immediately previous cell capacity difference dSOH_n-1) for each of the plurality of battery cells 10_1 to 10_4 (S4). The accumulation cycle is updated every time the accumulated energy value increases by the reference energy unit.

When the accumulation cycle is updated (when the accumulated energy value increases by the reference energy unit), the degradation degree diagnosis unit 134 may request the cell capacity difference calculation unit 133 for a cell capacity difference for each of the plurality of battery cells 10_1 to 10_4. The cell capacity calculation unit 132 may transmit a current cell capacity difference dSOH_n, which is a cell capacity difference calculated at a time point closest to the time point at which the request is received, to the degradation degree diagnosis unit 134. The degradation degree diagnosis unit 134 may store the current cell capacity difference dSOH_n received in response to the request. The degradation degree diagnosis unit 134 calculates a slope between the current cell capacity difference dSOH_n and the immediately previous pre-stored cell capacity difference dSOH_n-1 every accumulation cycle. For example, the degradation degree diagnosis unit 134 may calculate the slope by dividing a value obtained by subtracting the immediately previous cell capacity difference dSOH_n-1 from the current cell capacity difference dSOH_n by the reference energy. Since the cell capacity is a ratio of a cell capacity at a time point when the cell capacity is calculated to the initial cell capacity of the battery cell, the unit of the cell capacity may be [%]. The unit of the accumulated energy may be [J] (joule).

The degradation degree diagnosis unit 134 may diagnose whether each battery cell is abnormal according to a result of comparing the degree of change in cell capacity difference calculated every accumulation cycle with a predetermined threshold value (S5). The degradation degree diagnosis unit 134 may diagnose a battery cell for which the calculated slope is greater than or equal to the predetermined degradation threshold value among the plurality of battery cells 10_1 to 10_4 as an abnormal cell.

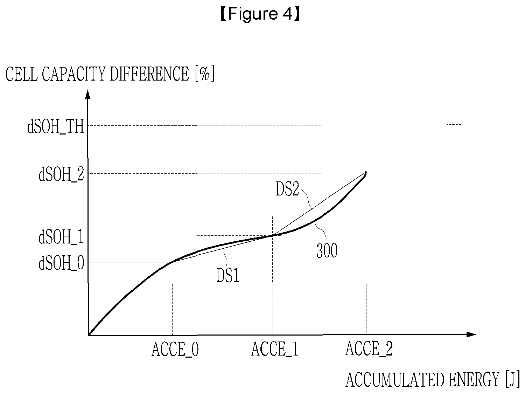

FIG. 4 is a graph showing a relationship between a cell capacity difference and accumulated energy according to an exemplary embodiment.

FIG. 4 is an example for explaining the invention, and the invention is not limited thereto. In FIG. 4, the horizontal axis is an axis related to accumulated energy, on which a position indicating accumulated energy moves further in the rightward direction as the accumulated energy increases, and the vertical axis is an axis related to a cell capacity difference, on which a position indicating a cell capacity difference moves further in the upward direction as the cell capacity difference increases.
"dSOH_TH" shown on the vertical axis of FIG. 4 is a fixed value, and is a cell capacity difference threshold value for determining whether a battery cell is normal. Conventionally, when the cell capacity difference reaches "dSOH_TH", the corresponding cell can be diagnosed as a cell that is abnormal due to degradation.

A graph 300 illustrated in FIG. 4 is a graph showing a cell capacity difference with respect to accumulated energy of a certain battery cell among the plurality of battery cells 10_1 to 10_4.

At a time point when the accumulated energy reaches "ACCE_1", the degradation degree diagnosis unit 134 calculates a slope DS1 between an immediately previous cell capacity difference dSOH_0 when the accumulated energy is "ACCE_0" and a current cell capacity difference dSOH_1 when the accumulated energy is "ACCE_1". The slope DS1 has a value smaller than the degradation threshold value, and the degradation degree diagnosis unit 134 determines that the battery cell is normal.

At a time point when the accumulated energy reaches "ACCE_2", the degradation degree diagnosis unit 134 calculates a slope DS2 between an immediately previous cell capacity difference dSOH_1 when the accumulated energy is "ACCE_1" and a current cell capacity difference dSOH_2 when the accumulated energy is "ACCE_2". The slope DS2 has a value greater than or equal to the degradation threshold value, and the degradation degree diagnosis unit 134 determines that the battery cell is abnormal.

The degradation threshold value may be a constant value or a value that varies depending on accumulated energy. For example, as the accumulated energy increases, the degradation threshold value may increase.

In an exemplary embodiment, as compared to the conventional method, even though the current cell capacity difference dSOH_2 is smaller than "dSOH_TH", it can be determined that the corresponding battery cell is abnormal. According to the conventional method, while the cell capacity difference of the battery cell progresses from the current cell capacity difference dSOH_2 to "dSOH_TH", the other battery cells may be affected. In contrast, the battery system according to an exemplary embodiment is capable of detecting an abnormal battery cell of which a degree of cell capacity degradation is high at an early stage by calculating a degree of change in cell capacity difference.

When an abnormal battery cell is detected, the BMS 100 may notify the outside. The outside may include a terminal or server that manages the battery system 1, a higher-level controller of a device on which the battery system 1 is mounted, or the like. By detecting an abnormal battery cell, if the abnormal battery cell is replaced in the battery pack 10, the influences on degrees of cell capacity degradation of the other battery cells can be blocked.

Although the exemplary embodiments of the present disclosure have been described in detail above, the scope of the present disclosure is not limited thereto. Various modifications and improvements made by those skilled in the art using the basic concept of the present disclosure defined in the appended claims also fall within the scope of the present disclosure.

## Claims

1. A battery system comprising:
a battery pack (10) including a plurality of battery cells (10_1, ..., 10_4),
a current sensor (23) that measures a battery pack current flowing through the battery pack (10), and generates a current sensing signal indicating the measured battery pack current;
a cell monitoring IC (110) that measures a battery pack voltage of the battery pack (10) and a cell voltage of each of the plurality of battery cells (10_1, ..., 10_4), and generates a voltage sensing signal indicating the measured battery pack voltage and the measured plurality of cell voltages; and
a main control circuit (130) that computes accumulated energy for the battery pack (10) using the current sensing signal and the voltage sensing signal, calculates a cell capacity of each of the plurality of battery cells (10_1, ..., 10_4) every predetermined cell capacity calculation cycle, calculates a degree of change in cell capacity difference for each of the plurality of battery cells (10_1, ..., 10_4) every accumulation cycle during which the accumulated energy increases by a predetermined unit, and diagnoses whether each battery cell is abnormal according to a result of comparing the degree of change in cell capacity difference calculated every accumulation cycle with a predetermined threshold value.

2. The battery system of claim 1, wherein
the main control circuit includes an energy accumulation unit (131) that computes one of charging energy and discharging energy for the battery pack (10) as the accumulated energy, using a battery pack current indicated by the current sensing signal and a battery pack voltage indicated by the voltage sensing signal.

3. The battery system of claim 2, wherein
the energy accumulation unit (131)
calculates accumulated energy by multiplying a battery pack current and a battery pack voltage every monitoring cycle during a charging period in which the battery pack (10) is charged to calculate charging energy, and integrating the charging energy calculated during the charging period, or
calculates accumulated energy by multiplying a battery pack current and a battery pack voltage every monitoring cycle during a discharging period in which the battery pack (10) is discharged to calculate discharging energy, and integrating the discharging energy calculated during the discharging period.

4. The battery system of claim 1, wherein
the main control circuit (130) includes a cell capacity calculation unit (132) that calculates cell capacities for each of the plurality of battery cells (10_1, ..., 10_4) in units of the cell capacity calculation cycle, and stores the calculated plurality of cell capacities,
the cell capacity calculation cycle being a period from a time point when the main control circuit (130) is powered on to a time point when the main control circuit (130) is powered off.

5. The battery system of claim 4, wherein
the cell capacity calculation unit (132) accumulates a current flowing through each of the plurality of battery cells (10_1, ..., 10_4)during the cell capacity calculation cycle and calculates an accumulated current amount of each of the plurality of battery cells (10_1, ..., 10_4), calculates an SOC change amount of each of the plurality of battery cells (10_1, ..., 10_4) during the cell capacity calculation cycle, and calculates a cell capacity by dividing the accumulated current amount by the SOC change amount during the cell capacity calculation cycle for each of the plurality of battery cells(10_1, ..., 10_4).

6. The battery system of claim 5, wherein
the cell capacity calculation unit (132) estimates an SOC at a start time point of the cell capacity calculation cycle and an SOC at an end time point of the cell capacity calculation cycle based on a cell voltage of each of the plurality of battery cells (10_1, ..., 10_4) indicated by the voltage sensing signal or an open circuit voltage (OCV) corresponding to the cell voltage of each of the plurality of battery cells (10_1, ..., 10_4), and calculates a difference between the SOC at the start time point and the SOC at the end time point as the SOC change amount.

7. The battery system of claim 4, wherein
the main control circuit (130) further includes a cell capacity difference calculation unit (133) that calculates a cell capacity difference for a cell capacity of each of the plurality of battery cells (10_1, ..., 10_4)every cell capacity calculation cycle,
the cell capacity difference being a change in cell capacity during the cell capacity calculation cycle for each of the plurality of battery cells (10_1, ..., 10_4).

8. The battery system of claim 7, wherein
the cell capacity difference calculation unit (133) calculates, as the cell capacity difference for each battery cell, a difference between a cell capacity at a start time point of a nth cell capacity calculation cycle and a cell capacity at an end time point of the nth cell capacity calculation cycle for each of the plurality of battery cells (10_1, ..., 10_4),
the "n" being a natural number greater than or equal to 1 that indicates the number of times the cell capacity calculation cycle has elapsed from a time point at which the battery pack (10) began to be used to an arbitrary time point.

9. The battery system of claim 1, wherein
the main control circuit (130) includes a degradation degree diagnosis unit (134) that stores a cell capacity difference for each of the plurality of battery cells (10_1, ..., 10_4) during a cell capacity calculation cycle corresponding to a time point at which a value of the accumulated energy increases by a predetermined reference energy unit, calculates a slope between a current cell capacity difference corresponding to a current accumulation cycle and an immediately previous cell capacity difference corresponding to an immediately previous accumulation cycle for each of the plurality of battery cells (10_1, ..., 10_4), and diagnoses a battery cell for which the calculated slope is greater than or equal to a predetermined degradation threshold value as an abnormal cell.

10. A method for diagnosing degrees of degradation of a plurality of battery cells (10_1, ..., 10_4) constituting a battery pack (10) by a battery management system, the method comprising:
computing accumulated energy for the battery pack (10) using a battery pack current flowing through the battery pack (10) and a battery pack voltage that is a voltage of the battery pack (10);
calculating a cell capacity of each of the plurality of battery cells (10_1, ..., 10_4) every predetermined cell capacity calculation cycle;
calculating a cell capacity difference every cell capacity calculation cycle for each of the plurality of battery cells (10_1, ..., 10_4);
calculating a degree of change in cell capacity difference for each of the plurality of battery cells (10_1, ... , 10_4) every accumulation cycle during which the accumulated energy increases by a predetermined unit; and
diagnosing whether each battery cell is abnormal according to a result of comparing the degree of change in cell capacity difference calculated every accumulation cycle with a predetermined threshold value.

11. The method of claim 10, wherein
the computing of the accumulated energy includes
calculating accumulated energy by multiplying a battery pack current and a battery pack voltage every monitoring cycle during a charging period in which the battery pack (10 is charged to calculate charging energy, and integrating the charging energy calculated during the charging period, or
calculating accumulated energy by multiplying a battery pack current and a battery pack voltage every monitoring cycle during a discharging period in which the battery pack (10) is discharged to calculate discharging energy, and integrating the discharging energy calculated during the discharging period.

12. The method of claim 10, wherein
the calculating of the cell capacity includes:
accumulating a current flowing through each of the plurality of battery cells (10_1, ..., 10_4) during the cell capacity calculation cycle and calculating an accumulated current amount of each of the plurality of battery cells (10_1, ..., 10_4);
calculating an SOC change amount of each of the plurality of battery cells (10_1, ... , 10_4) during the cell capacity calculation cycle; and
calculating a cell capacity by dividing the accumulated current amount by the SOC change amount during the cell capacity calculation cycle for each of the plurality of battery cells (10_1, ..., 10_4),
the cell capacity calculation cycle being a period from a time point when the main control circuit is powered on to a time point when the main control circuit is powered off.

13. The method of claim 12, wherein
the calculating of the SOC change amount includes
estimating an SOC at a start time point of the cell capacity calculation cycle and an SOC at an end time point of the cell capacity calculation cycle based on a cell voltage of each of the plurality of battery cells (10_1, ..., 10_4) indicated by a voltage sensing signal or an open circuit voltage (OCV) corresponding to the cell voltage of each of the plurality of battery cells (10_1, ..., 10_4), and calculating a difference between the SOC at the start time point and the SOC at the end time point as the SOC change amount.

14. The method of claim 10, wherein
the calculating of the cell capacity difference includes
calculating, as the cell capacity difference for eachbattery cell, a difference between a cell capacity at a start time point of a nth cell capacity calculation cycle and a cell capacity at an end time point of the nth cell capacity calculation cycle for each of the plurality of battery cells (10_1, ..., 10_4),
the cell capacity difference being a change in cell capacity during the cell capacity calculation cycle for each of the plurality of battery cells (10_1, ..., 10_4), and
the "n" being a natural number greater than or equal to 1 that indicates the number of times the cell capacity calculation cycle has elapsed from a time point at which the battery pack (10) began to be used to an arbitrary time point.

15. The method of claim 10, wherein
the calculating of the degree of change in cell capacity difference includes:
storing a cell capacity difference for each of the plurality of battery cells (10_1, ..., 10_4) during a cell capacity calculation cycle corresponding to a time point at which a value of the accumulated energy increases by a predetermined reference energy unit; and
calculating a slope between a current cell capacity difference corresponding to a current accumulation cycle and an immediately previous cell capacity difference corresponding to an immediately previous accumulation cycle for each of the plurality of battery cells (10_1, ..., 10_4).

## Patentansprüche

1. Batteriesystem umfassend:
einen Batteriepack (10), der eine Vielzahl von Batteriezellen (10_1, ..., 10_4) beinhaltet;
einen Stromsensor (23), der einen durch den Batteriepack (10) fließenden Batteriepackstrom misst und ein Stromerfassungssignal erzeugt, das den gemessenen Batteriepackstrom angibt;
ein Zellenüberwachungs-IC (110), das eine Batteriepackspannung des Batteriepacks (10) und eine Zellenspannung von jeder der Vielzahl von Batteriezellen (10_1, ..., 10_4) misst und ein Spannungserfassungssignal erzeugt, das die gemessene Batteriepackspannung und die gemessene Vielzahl von Zellenspannungen angibt; und
eine Hauptsteuerschaltung (130), der unter Verwendung des Stromerfassungssignals und des Spannungserfassungssignals akkumulierte Energie für den Batteriepack (10) berechnet, eine Zellenkapazität von jeder der Vielzahl von Batteriezellen (10_1, ..., 10_4) in jedem vorbestimmten Zellenkapazitätsberechnungszyklus berechnet, einen Änderungsgrad der Zellenkapazitätsdifferenz für jede der Vielzahl von Batteriezellen (10_1, ..., 10_4) in jedem Akkumulationszyklus berechnet, in dem sich die akkumulierte Energie um eine vorbestimmte Einheit erhöht, und gemäß einem Ergebnis des Vergleichens des in jedem Akkumulationszyklus berechneten Änderungsgrads der Zellenkapazitätsdifferenz mit einem vorbestimmten Schwellenwert diagnostiziert, ob jede Batteriezelle abnormal ist.

2. Batteriesystem nach Anspruch 1, wobei
die Hauptsteuerschaltung eine Energieakkumulationseinheit (131) beinhaltet, die eine von einer Ladeenergie und einer Entladeenergie für den Batteriepack (10) als die akkumulierte Energie unter Verwendung eines durch das Stromerfassungssignal angegebenen Batteriepackstroms und einer durch das Spannungserfassungssignal angegebenen Batteriepackspannung berechnet.

3. Batteriesystem nach Anspruch 2, wobei
die Energieakkumulationseinheit (131)
akkumulierte Energie durch Multiplizieren eines Batteriepackstroms und einer Batteriepackspannung in jedem Überwachungszyklus während eines Ladezeitraums, in dem der Batteriepack (10) geladen wird, um die Ladeenergie zu berechnen, und Integrieren der während des Ladezeitraums berechnete Ladeenergie berechnet, oder
akkumulierte Energie durch Multiplizieren eines Batteriepackstroms und einer Batteriepackspannung in jedem Überwachungszyklus während eines Entladezeitraums, in dem der Batteriepack (10) entladen wird, um die Entladeenergie zu berechnen, und Integrieren der während des Entladezeitraums berechnete Entladeenergie berechnet.

4. Batteriesystem nach Anspruch 1, wobei
die Hauptsteuerschaltung (130) eine Zellenkapazitätsberechnungseinheit (132) beinhaltet,
die Zellenkapazitäten für jede der Vielzahl von Batteriezellen (10_1, ..., 10_4) in Einheiten des Zellenkapazitätsberechnungszyklus berechnet und die berechnete Vielzahl von Zellenkapazitäten speichert,
wobei der Zellenkapazitätsberechnungszyklus ein Zeitraum von einem Zeitpunkt, zu dem die Hauptsteuerschaltung (130) eingeschaltet wird, bis zu einem Zeitpunkt, zu dem die Hauptsteuerschaltung (130) ausgeschaltet wird, ist.

5. Batteriesystem nach Anspruch 4, wobei
die Zellenkapazitätsberechnungseinheit (132) einen durch jede der Vielzahl von Batteriezellen (10_1, ..., 10_4) fließenden Strom während des Zellenkapazitätsberechnungszyklus akkumuliert und eine akkumulierte Strommenge von jeder der Vielzahl von Batteriezellen (10_1, ..., 10_4)berechnet, einen SOC-Änderungsbetrag von jeder der Vielzahl von Batteriezellen (10_1, ..., 10_4) während des Zellenkapazitätsberechnungszyklus berechnet und eine Zellenkapazität durch Dividieren der akkumulierten Strommenge durch den SOC-Änderungsbetrag während des Zellenkapazitätsberechnungszyklus für jede der Vielzahl von Batteriezellen (10_1, ..., 10_4) berechnet.

6. Batteriesystem nach Anspruch 5, wobei
die Zellenkapazitätsberechnungseinheit (132) einen SOC zu einem Startzeitpunkt des Zellenkapazitätsberechnungszyklus und einen SOC zu einem Endzeitpunkt des Zellenkapazitätsberechnungszyklus basierend auf einer durch das Spannungserfassungssignal angegebenen Zellenspannung von jeder der Vielzahl von Batteriezellen (10_1, ..., 10_4) oder einer Leerlaufspannung (OCV), die der Zellenspannung von jeder der Vielzahl von Batteriezellen (10_1, ..., 10_4) entspricht, schätzt und eine Differenz zwischen dem SOC zum Startzeitpunkt und dem SOC zum Endzeitpunkt als den SOC-Änderungsbetrag berechnet.

7. Batteriesystem nach Anspruch 4, wobei
die Hauptsteuerschaltung (130) weiter eine Zellenkapazitätsdifferenz-Berechnungseinheit (133) beinhaltet, die eine Zellenkapazitätsdifferenz für eine Zellenkapazität von jeder der Vielzahl von Batteriezellen (10_1, ..., 10_4) in jedem Zellenkapazitätsberechnungszyklus berechnet,
wobei die Zellenkapazitätsdifferenz eine Änderung der Zellenkapazität während des Zellenkapazitätsberechnungszyklus für jede der Vielzahl von Batteriezellen (10_1, ..., 10_4) ist.

8. Batteriesystem nach Anspruch 7, wobei
die Zellenkapazitätsdifferenz-Berechnungseinheit (133) als die Zellenkapazitätsdifferenz für jede Batteriezelle eine Differenz zwischen einer Zellenkapazität zu einem Startzeitpunkt eines n^{ten} Zellenkapazitätsberechnungszyklus und einer Zellenkapazität zu einem Endzeitpunkt des n^{ten} Zellenkapazitätsberechnungszyklus für jede der Vielzahl von Batteriezellen (10_1, ..., 10_4) berechnet,
wobei das "n" eine natürliche Zahl größer als oder gleich 1 ist, die angibt, wie oft der Zellenkapazitätsberechnungszyklus ab einem Zeitpunkt, zu dem die Verwendung des Batteriepacks (10) begann, bis zu einem beliebigen Zeitpunkt abgelaufen ist,

9. Batteriesystem nach Anspruch 1, wobei
die Hauptsteuerschaltung (130) eine Schädigungsgrad-Diagnoseeinheit (134) beinhaltet, die eine Zellenkapazitätsdifferenz für jede der Vielzahl von Batteriezellen (10_1, ..., 10_4) während eines Zellenkapazitätsberechnungszyklus speichert, der einem Zeitpunkt entspricht, an dem sich ein Wert der akkumulierten Energie um eine vorbestimmte Referenzenergieeinheit erhöht, eine Steigung zwischen einer aktuellen Zellenkapazitätsdifferenz entsprechend einem aktuellen Akkumulationszyklus und einer unmittelbar vorherigen Zellenkapazitätsdifferenz entsprechend einem unmittelbar vorherigen Akkumulationszyklus für jede der Vielzahl von Batteriezellen (10_1, ..., 10_4) berechnet, und eine Batteriezelle, für die die berechnete Steigung größer als oder gleich einem vorbestimmten Schädigungsschwellenwert ist, als eine abnormale Zelle diagnostiziert,

10. Verfahren zum Diagnostizieren von Schädigungsgraden einer Vielzahl von Batteriezellen (10_1, ..., 10_4), die einen Batteriepack (10) bilden, durch ein Batteriemanagementsystem, wobei das Verfahren umfasst:
• Berechnen akkumulierter Energie für den Batteriepack (10) unter Verwendung eines durch den Batteriepack (10) fließenden Batteriepackstroms und einer Batteriepackspannung, die eine Spannung des Batteriepacks (10) ist;
• Berechnen einer Zellenkapazität von jeder der Vielzahl von Batteriezellen (10_1, ..., 10_4) in jedem vorbestimmten Zellenkapazitätsberechnungszyklus;
• Berechnen einer Zellenkapazitätsdifferenz in jedem Zellenkapazitätsberechnungszyklus für jede der Vielzahl von Batteriezellen (10_1, ..., 10_4);
• Berechnen eines Änderungsgrads der Zellenkapazitätsdifferenz für jede der Vielzahl von Batteriezellen (10_1, ..., 10_4) in jedem Akkumulationszyklus, in dem sich die akkumulierte Energie um eine vorbestimmte Einheit erhöht; und
• Diagnostizieren, ob jede Batteriezelle abnormal ist, gemäß einem Ergebnis des Vergleichens des in jedem Akkumulationszyklus berechneten Änderungsgrads der Zellenkapazitätsdifferenz mit einem vorbestimmten Schwellenwert.

11. Verfahren nach Anspruch 10, wobei
das Berechnen der akkumulierten Energie beinhaltet
Berechnen von akkumulierter Energie durch Multiplizieren eines Batteriepackstroms und einer Batteriepackspannung in jedem Überwachungszyklus während eines Ladezeitraums, in dem der Batteriepack (10) geladen wird, um Ladeenergie zu berechnen, und Integrieren der während des Ladezeitraums berechneten Ladeenergie, oder
Berechnen von akkumulierter Energie durch Multiplizieren eines Batteriepackstroms und einer Batteriepackspannung in jedem Überwachungszyklus während eines Entladezeitraums, in dem der Batteriepack (10) entladen wird, um Entladeenergie zu berechnen, und Integrieren der während des Entladezeitraums berechneten Entladeenergie.

12. Verfahren nach Anspruch 10, wobei
das Berechnen der Zellenkapazität beinhaltet:
• Akkumulieren eines durch jede der Vielzahl von Batteriezellen (10_1, ..., 10_4) fließenden Stroms während des Zellenkapazitätsberechnungszyklus und Berechnen einer akkumulierten Strommenge von jeder der Vielzahl von Batteriezellen (10_1, ..., 10_4);
• Berechnen eines SOC-Änderungsbetrags von jeder der Vielzahl von Batteriezellen (10_1, ..., 10_4) während des Zellenkapazitätsberechnungszyklus; und
• Berechnen einer Zellenkapazität durch Dividieren der akkumulierten Strommenge durch den SOC-Änderungsbetrag während des Zellenkapazitätsberechnungszyklus für jede der Vielzahl von Batteriezellen (10_1, ..., 10_4),
wobei der Zellenkapazitätsberechnungszyklus ein Zeitraum von einem Zeitpunkt, zu dem die Hauptsteuerschaltung eingeschaltet wird, bis zu einem Zeitpunkt, zu dem die Hauptsteuerschaltung ausgeschaltet wird, ist.

13. Verfahren nach Anspruch 12, wobei
das Berechnen des SOC-Änderungsbetrags beinhaltet
Schätzen eines SOC zu einem Startzeitpunkt des Zellenkapazitätsberechnungszyklus und eines SOC zu einem Endzeitpunkt des Zellenkapazitätsberechnungszyklus basierend auf einer durch ein Spannungserfassungssignal angegebenen Zellenspannung von jeder der Vielzahl von Batteriezellen (10_1, ..., 10_4) oder einer Leerlaufspannung (OCV), die der Zellenspannung von jeder der Vielzahl von Batteriezellen (10_1, ..., 10_4) entspricht, und Berechnen einer Differenz zwischen dem SOC zum Startzeitpunkt und dem SOC zum Endzeitpunkt als den SOC-Änderungsbetrag.

14. Verfahren nach Anspruch 10, wobei
das Berechnen der Zellenkapazitätsdifferenz beinhaltet
Berechnen, als die Zellenkapazitätsdifferenz für jede Batteriezelle, einer Differenz zwischen einer Zellenkapazität zu einem Startzeitpunkt eines n^{ten} Zellenkapazitätsberechnungszyklus und einer Zellenkapazität zu einem Endzeitpunkt des n^{ten} Zellenkapazitätsberechnungszyklus für jede der Vielzahl von Batteriezellen (10_1, ..., 10_4),
wobei die Zellenkapazitätsdifferenz eine Änderung der Zellenkapazität während des Zellenkapazitätsberechnungszyklus für jede der Vielzahl von Batteriezellen (10_1, ..., 10_4) ist, und
wobei das "n" eine natürliche Zahl größer als oder gleich 1 ist, die angibt, wie oft der Zellenkapazitätsberechnungszyklus ab einem Zeitpunkt, zu dem die Verwendung des Batteriepacks (10) begann, bis zu einem beliebigen Zeitpunkt abgelaufen ist.

15. Verfahren nach Anspruch 10, wobei
das Berechnen des Änderungsgrads der Zellenkapazitätsdifferenz beinhaltet:
• Speichern einer Zellenkapazitätsdifferenz für jede der Vielzahl von Batteriezellen (10_1, ..., 10_4) während eines Zellenkapazitätsberechnungszyklus, der einem Zeitpunkt entspricht, an dem sich ein Wert der akkumulierten Energie um eine vorbestimmte Referenzenergieeinheit erhöht; und
• Berechnen einer Steigung zwischen einer aktuellen Zellenkapazitätsdifferenz entsprechend einem aktuellen Akkumulationszyklus und einer unmittelbar vorherigen Zellenkapazitätsdifferenz entsprechend einem unmittelbar vorherigen Akkumulationszyklus für jede der Vielzahl von Batteriezellen (10_1, ..., 10_4).

## Revendications

1. Un système de batterie comprenant :
un bloc-batterie (10) comprenant une pluralité de cellules de batterie (10_1, ..., 10_4) ;
un capteur de courant (23) qui mesure un courant de bloc-batterie circulant à travers le bloc-batterie (10), et génère un signal de détection de courant indiquant le courant de bloc-batterie mesuré ;
un CI de surveillance de cellule (110) qui mesure une tension de bloc-batterie du bloc-batterie (10) et une tension de cellule de chacune de la pluralité de cellules de batterie (10_1, ..., 10_4), et génère un signal de détection de tension indiquant la tension de bloc-batterie mesurée et la pluralité de tensions de cellule mesurées; et
un circuit de commande principal (130) qui calcule l'énergie accumulée pour le bloc-batterie (10) en utilisant le signal de détection de courant et le signal de détection de tension, calcule une capacité de cellule de chacune de la pluralité de cellules de batterie (10_1, ..., 10_4) à chaque cycle de calcul de capacité de cellule prédéterminé, calcule un degré de variation de différence de capacité de cellule pour chacune de la pluralité de cellules de batterie (10_1, ..., 10_4) à chaque cycle d'accumulation au cours duquel l'énergie accumulée augmente d'une unité prédéterminée, et diagnostique si chaque cellule de batterie est anormale selon un résultat de la comparaison du degré de variation de différence de capacité de cellule calculé à chaque cycle d'accumulation avec une valeur de seuil prédéterminée.

2. Le système de batterie selon la revendication 1, dans lequel le circuit de commande principal comprend une unité d'accumulation d'énergie (131) qui calcule l'une d'une énergie de charge et d'une énergie de décharge pour le bloc-batterie (10) en tant qu'énergie accumulée, en utilisant un courant de bloc-batterie indiqué par le signal de détection de courant et une tension de bloc-batterie indiquée par le signal de détection de tension.

3. Le système de batterie selon la revendication 2, dans lequel l'unité d'accumulation d'énergie (131)
calcule l'énergie accumulée en multipliant un courant de bloc-batterie et une tension de bloc-batterie à chaque cycle de surveillance pendant une période de charge au cours de laquelle le bloc-batterie (10) est chargé pour calculer l'énergie de charge, et en intégrant l'énergie de charge calculée pendant la période de charge, ou
calcule l'énergie accumulée en multipliant un courant de bloc-batterie et une tension de bloc-batterie à chaque cycle de surveillance pendant une période de décharge au cours de laquelle le bloc-batterie (10) est déchargé pour calculer l'énergie de décharge, et en intégrant l'énergie de décharge calculée pendant la période de décharge.

4. Le système de batterie selon la revendication 1, dans lequel le circuit de commande principal (130) comprend une unité de calcul de capacité de cellule (132) qui calcule des capacités de cellule pour chacune de la pluralité de cellules de batterie (10_1, ..., 10_4) en unités du cycle de calcul de capacité de cellule, et stocke la pluralité de capacités de cellule calculées, le cycle de calcul de capacité de cellule étant une période allant d'un moment où le circuit de commande principal (130) est mis sous tension jusqu'à un moment où le circuit de commande principal (130) est mis hors tension.

5. Le système de batterie selon la revendication 4, dans lequel l'unité de calcul de capacité de cellule (132) accumule un courant circulant à travers chacune de la pluralité de cellules de batterie (10_1, ..., 10_4) pendant le cycle de calcul de capacité de cellule et calcule une quantité de courant accumulé de chacune de la pluralité de cellules de batterie (10_1, ..., 10_4), calcule une quantité de variation de SOC de chacune de la pluralité de cellules de batterie (10_1, ..., 10_4) pendant le cycle de calcul de capacité de cellule, et calcule une capacité de cellule en divisant la quantité de courant accumulé par la quantité de variation de SOC pendant le cycle de calcul de capacité de cellule pour chacune de la pluralité de cellules de batterie (10_1, ..., 10_4).

6. Le système de batterie selon la revendication 5, dans lequel l'unité de calcul de capacité de cellule (132) estime un SOC à un moment de début du cycle de calcul de capacité de cellule et un SOC à un moment de fin du cycle de calcul de capacité de cellule sur la base d'une tension de cellule de chacune de la pluralité de cellules de batterie (10_1, ..., 10_4) indiquée par le signal de détection de tension ou d'une tension en circuit ouvert (OCV) correspondant à la tension de cellule de chacune de la pluralité de cellules de batterie (10_1, ..., 10_4), et calcule une différence entre le SOC au moment de début et le SOC au moment de fin en tant que quantité de variation de SOC.

7. Le système de batterie selon la revendication 4, dans lequel le circuit de commande principal (130) comprend en outre une unité de calcul de différence de capacité de cellule (133) qui calcule une différence de capacité de cellule pour une capacité de cellule de chacune de la pluralité de cellules de batterie (10_1, ..., 10_4) à chaque cycle de calcul de capacité de cellule, la différence de capacité de cellule étant une variation de capacité de cellule pendant le cycle de calcul de capacité de cellule pour chacune de la pluralité de cellules de batterie (10_1, ..., 10_4).

8. Le système de batterie selon la revendication 7, dans lequel l'unité de calcul de différence de capacité de cellule (133) calcule, en tant que différence de capacité de cellule pour chaque cellule de batterie, une différence entre une capacité de cellule à un moment de début d'un n^{ième} cycle de calcul de capacité de cellule et une capacité de cellule à un moment de fin du n^{ième} cycle de calcul de capacité de cellule pour chacune de la pluralité de cellules de batterie (10_1, ..., 10_4), le « n » étant un nombre entier naturel supérieur ou égal à 1 qui indique le nombre de fois que le cycle de calcul de capacité de cellule s'est écoulé depuis un moment où le bloc-batterie (10) a commencé à être utilisé jusqu'à un moment arbitraire.

9. Le système de batterie selon la revendication 1, dans lequel le circuit de commande principal (130) comprend une unité de diagnostic de degré de dégradation (134) qui stocke une différence de capacité de cellule pour chacune de la pluralité de cellules de batterie (10_1, ..., 10_4) pendant un cycle de calcul de capacité de cellule correspondant à un moment où une valeur de l'énergie accumulée augmente d'une unité d'énergie de référence prédéterminée, calcule une pente entre une différence de capacité de cellule actuelle correspondant à un cycle d'accumulation actuel et une différence de capacité de cellule immédiatement précédente correspondant à un cycle d'accumulation immédiatement précédent pour chacune de la pluralité de cellules de batterie (10_1, ..., 10_4), et diagnostique une cellule de batterie pour laquelle la pente calculée est supérieure ou égale à une valeur de seuil de dégradation prédéterminée comme étant une cellule anormale.

10. Un procédé de diagnostic de degrés de dégradation d'une pluralité de cellules de batterie (10_1, ..., 10_4) constituant un bloc-batterie (10) par un système de gestion de batterie, le procédé comprenant :
calculer une énergie accumulée pour le bloc-batterie (10) en utilisant un courant de bloc-batterie circulant à travers le bloc-batterie (10) et une tension de bloc-batterie qui est une tension du bloc-batterie (10) ;
calculer une capacité de cellule de chacune de la pluralité de cellules de batterie (10_1, ..., 10_4) à chaque cycle de calcul de capacité de cellule prédéterminé ;
calculer une différence de capacité de cellule à chaque cycle de calcul de capacité de cellule pour chacune de la pluralité de cellules de batterie (10_1, ..., 10_4) ;
calculer un degré de variation de différence de capacité de cellule pour chacune de la pluralité de cellules de batterie (10_1, ..., 10_4) à chaque cycle d'accumulation au cours duquel l'énergie accumulée augmente d'une unité prédéterminée ; et
diagnostiquer si chaque cellule de batterie est anormale selon un résultat de la comparaison du degré de variation de différence de capacité de cellule calculé à chaque cycle d'accumulation avec une valeur de seuil prédéterminée.

11. Le procédé selon la revendication 10, dans lequel le calcul de l'énergie accumulée comprend
calculer l'énergie accumulée en multipliant un courant de bloc-batterie et une tension de bloc-batterie à chaque cycle de surveillance pendant une période de charge au cours de laquelle le bloc-batterie (10) est chargé pour calculer l'énergie de charge, et en intégrant l'énergie de charge calculée pendant la période de charge, ou
calculer l'énergie accumulée en multipliant un courant de bloc-batterie et une tension de bloc-batterie à chaque cycle de surveillance pendant une période de décharge au cours de laquelle le bloc-batterie (10) est déchargé pour calculer l'énergie de décharge, et en intégrant l'énergie de décharge calculée pendant la période de décharge.

12. Le procédé selon la revendication 10, dans lequel le calcul de la capacité de cellule comprend :
accumuler un courant circulant à travers chacune de la pluralité de cellules de batterie (10_1, ..., 10_4) pendant le cycle de calcul de capacité de cellule et calculer une quantité de courant accumulé de chacune de la pluralité de cellules de batterie (10_1, ..., 10_4) ;
calculer une quantité de variation de SOC de chacune de la pluralité de cellules de batterie (10_1, ..., 10_4) pendant le cycle de calcul de capacité de cellule ; et
calculer une capacité de cellule en divisant la quantité de courant accumulé par la quantité de variation de SOC pendant le cycle de calcul de capacité de cellule pour chacune de la pluralité de cellules de batterie (10_1, ..., 10_4),
le cycle de calcul de capacité de cellule étant une période allant d'un moment où le circuit de commande principal est mis sous tension jusqu'à un moment où le circuit de commande principal est mis hors tension.

13. Le procédé selon la revendication 12, dans lequel le calcul de la quantité de variation de SOC comprend
estimer un SOC à un moment de début du cycle de calcul de capacité de cellule et un SOC à un moment de fin du cycle de calcul de capacité de cellule sur la base d'une tension de cellule de chacune de la pluralité de cellules de batterie (10_1, ..., 10_4) indiquée par un signal de détection de tension ou d'une tension en circuit ouvert (OCV) correspondant à la tension de cellule de chacune de la pluralité de cellules de batterie (10_1, ..., 10_4), et calculer une différence entre le SOC au moment de début et le SOC au moment de fin en tant que quantité de variation de SOC.

14. Le procédé selon la revendication 10, dans lequel le calcul de la différence de capacité de cellule comprend
calculer, en tant que différence de capacité de cellule pour chaque cellule de batterie, une différence entre une capacité de cellule à un moment de début d'un n^{ième} cycle de calcul de capacité de cellule et une capacité de cellule à un moment de fin du n^{ième} cycle de calcul de capacité de cellule pour chacune de la pluralité de cellules de batterie (10_1, ..., 10_4), la différence de capacité de cellule étant une variation de capacité de cellule pendant le cycle de calcul de capacité de cellule pour chacune de la pluralité de cellules de batterie (10_1, ..., 10_4), le « n » étant un nombre entier naturel supérieur ou égal à 1 qui indique le nombre de fois que le cycle de calcul de capacité de cellule s'est écoulé depuis un moment où le bloc-batterie (10) a commencé à être utilisé jusqu'à un moment arbitraire.

15. Le procédé selon la revendication 10, dans lequel le calcul du degré de variation de différence de capacité de cellule comprend :
stocker une différence de capacité de cellule pour chacune de la pluralité de cellules de batterie (10_1, ..., 10_4) pendant un cycle de calcul de capacité de cellule correspondant à un moment où une valeur de l'énergie accumulée augmente d'une unité d'énergie de référence prédéterminée ; et
calculer une pente entre une différence de capacité de cellule actuelle correspondant à un cycle d'accumulation actuel et une différence de capacité de cellule immédiatement précédente correspondant à un cycle d'accumulation immédiatement précédent pour chacune de la pluralité de cellules de batterie (10_1, ..., 10_4).
